(19) Europäisches Patentamt
European Patent Office
Office européen des brevets

(11) **EP 0 696 067 B1**

## (12) EUROPEAN PATENT SPECIFICATION

(45) Date of publication and mention
of the grant of the patent:
**02.06.1999  Bulletin 1999/22**

(51) Int Cl.⁶: **H01L 31/0352**, H01L 31/0304

(21) Application number: **94305112.8**

(22) Date of filing: **13.07.1994**

(54) **Semiconductor photodetector**

Halbleiter-Fotodetektor

Photodétecteur à semi-conducteur

(84) Designated Contracting States:
**DE FR GB**

(43) Date of publication of application:
**07.02.1996  Bulletin 1996/06**

(73) Proprietor: **HAMAMATSU PHOTONICS K.K.**
**Shizuoka-ken (JP)**

(72) Inventor: **Murakami, Tadayoshi**
**Hamamatsu-shi, Shizuoka-ken (JP)**

(74) Representative: **Burke, Steven David et al**
**R.G.C. Jenkins & Co.**
**26 Caxton Street**
**London SW1H 0RJ (GB)**

(56) References cited:
**EP-A- 0 178 673**          **EP-A- 0 470 783**
**EP-A- 0 554 846**

- **ELECTRONICS LETTERS, 31 MARCH 1988, UK, VOL. 24, NR. 7, PAGE(S) 379 - 380, ISSN 0013-5194 MAKITA ET AL 'Ga/sub 1-y/In/sub y/As/InAs/sub x/P/sub 1-1/ (y is greater than 0.53, x is greater than 0) pin photodiodes for long wavelength regions ( lambda is greater than 2 mu m) grown by hydride vapour phase epitaxy'**
- **JAPANESE JOURNAL OF APPLIED PHYSICS, PART 2 (LETTERS), 15 AUG. 1991, JAPAN, VOL. 30, NR. 8B, PAGE(S) L1501 - L1504, ISSN 0021-4922 Wada M et al 'Wide-wavelength GaInAs PIN photodiodes using a lattice-mismatched light-absorbing layer and a thin InP cap layer'**

**Description**

BACKGROUND OF THE INVENTION

Field of the Invention

The present invention relates to a semiconductor photodetector for detecting incident light.

Related Background Art

Currently, an $In_{1-x}Ga_xAs$ mixed crystal is well known as one of mixed crystal semiconductor materials usable for photodetection. By controlling the composition ratio of this mixed crystal semiconductor to change the forbidden bandgap, this mixed crystal can be used as the light-absorbing layer of a photodetector for optical communication, spectrophotometer, etc. When the composition ratio of this $In_{1-x}Ga_xAs$ mixed crystal is changed, a mixed crystal semiconductor having various bandgaps ranging from that of InAs = 0.36 eV to that of GaAs = 1.42 eV can be made. For example, with x = 0.35, $In_{0.65}Ga_{0.35}As$ has a forbidden bandgap = 0.48 eV. This mixed crystal can be used as a light-absorbing layer to manufacture a photodetector having a sensitivity up to a wavelength of 2.0 μm. As the value x becomes smaller, a photodetector having a sensitivity to a longer wavelength can be made.

However, when the composition ratio of the mixed crystal is changed, not only the bandgap but also the lattice constant changes. When x = 0.35, the lattice constant = 5.9166 Å which is largely different from that of InP = 5.8688 Å. Generally, when a crystal having a lattice constant largely different from that of a substrate is grown on the substrate, a lot of dislocations are induced from its interface to degrade the crystallin quality. For this reason, no crystal suitable for practical use can be obtained. However, when the difference between the lattice constants is very small, a relatively satisfactory epitaxial layer can be obtained. By using this, the composition ratio of the mixed crystal is changed in the growing direction of the epitaxial layer to gradually change the lattice constant, thereby finally growing an epitaxial layer having a composition ratio with a desired lattice constant, i.e., bandgap. These layers are called a graded layer as a whole. When a photodetector is to be manufactured, a light-absorbing layer and a capping layer are sequentially epitaxially grown on the surface of the graded layer. Conventionally, to maintain the good crystallinity of the light-absorbing layer, a composition ratio is applied such that the lattice constants of the uppermost layer of the graded layer and the capping layer are equalized with that of the light-absorbing layer.

The conventional semiconductor photodetector has the above structure. With this structure, however, since a dark current is large, weak incident light cannot be detected with high accuracy.

Reference is made to Electronics Letters volume 24, No. 7, 31 March 1988, pages 379-380, in which there is described an arrangement for producing pin photodiodes for long wavelength regions (λ > 2μm) grown by hydride vapour phase epitaxy. A semiconductor photodetector is described in which a light-absorbing layer is disposed between, on the one hand, a graded layer comprising at least two stacked mixed crystal sublayers with different lattice constants and, on the other hand, a capping layer with a conduction zone formed therein. The light-absorbing layer is latticed-matched to the top of the graded layer.

Reference is also made to EP-A-0178673, which described a crystal structure in which an epitaxial layer is grown on a graded substrate. The crystal quality of the epitaxial layer is improved if the degree of mismatch between the lattice constant of the layer on which the epitaxial layer is grown and the lattice constant of said epitaxial layer is between $-1.10^{-3}$ and $-5.10^{-3}$.

SUMMARY OF THE INVENTION

It is an object of the present invention to provide a semiconductor photodetector capable of reducing a dark current value.

According to the present invention, there is provided a semiconductor photodetector comprising:

a substrate consisting of a compound semiconductor crystal having a first conductivity type;
a first electrode formed on a first surface of said substrate;
a graded layer having stacked mixed crystal sublayers sequentially epitaxially grown on the second surface of said substrate and consisting of at least two types of compound semiconductors having the first conductivity type and different composition ratios;
a light-absorbing layer epitaxially grown on the surface of said graded layer;
a capping layer, formed on the surface of said light-absorbing layer, and consisting of a compound semiconductor mixed crystal having the first conductivity type;
a first doped diffused zone extending in said capping layer, and having a second conductivity type; and

a second electrode formed on a surface of said first doped zone,

   characterised in that:

a second doped diffused zone having a second conductivity type is formed adjacent said first doped zone in the surface of said light-absorbing layer;
in that the capping layer and the sublayer adjacent the light-absorbing layer have almost the same lattice constants which are greater than that of the light-absorbing layer, the degree of mismatch between the lattice constant of the light-absorbing layer and the lattice constants of each of the capping layer and the said sublayer respectively being between -0.5% and -0.2%, whereby a dark current of the semiconductor photodetector is decreased by tensile forces acting in the direction of the respective interfaces between the light-absorbing layer and each of the capping layer and the sublayer, said forces tending to increase the lattice constant of the light-absorbing layer.

It is preferable that ① the substrate consists of an n-type InP crystal, ② the graded layer consists of at least two n-type InAsP mixed crystal sublayers having different composition ratios of As and P to In, ③ the light-absorbing layer consists of an n-type InGaAs mixed crystal, and ④ the capping layer consists of an n-type InAsP mixed crystal.

Another embodiment of the present invention further comprises, between the substrate and the graded layer, a buffer layer consisting of the compound semiconductor crystal forming the substrate having the first conductivity type.

It is preferable that the buffer layer consists of an n-type InP crystal.

The doped zones can be formed by diffusing Zn in the InAsP mixed crystal forming the capping layer and the InGaAs mixed crystal forming the light-absorbing layer.

In the semiconductor photodetector of the present invention, when the light-absorbing layer is illuminated, a current is generated in accordance with the light intensity to provide a function as a photodetector, as in the prior art. At the same time, the light-absorbing layer receives a tensile force from the uppermost layer of the graded layer, and the capping layer which are formed on the upper or lower side of the light-absorbing layer and have lattice constants larger than that of the light-absorbing layer. This tensile force serves to increase the lattice constant of the light-absorbing layer, thereby suppressing the dark current.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since modifications within the scope of the invention will become apparent to those skilled in the art from this detailed description.

## BRIEF DESCRIPTION OF THE DRAWINGS

Fig. 1 is a sectional view showing the structure of a semiconductor photodetector according to an embodiment of the present invention; and
Fig. 2 is a graph showing reduction of a dark current by the semiconductor photodetector according to the embodiment of the present invention.

## DETAILED DESCRIPTION OF THE PREFERRED EMBODIMENT

An embodiment of the present invention will be described below with reference to the accompanying drawings.

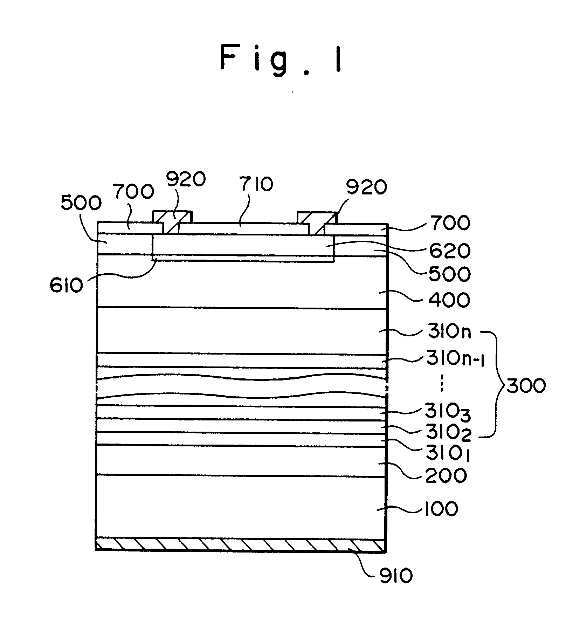

Fig. 1 is a sectional view showing the structure of a semiconductor photodetector according to an embodiment. This semiconductor photodetector is constituted by (a) a substrate 100 consisting of an n-type InP crystal, (b) a first electrode 910 formed on one surface of the substrate 100, (c) a buffer layer 200 (thickness of about 1 $\mu$m) formed on the other surface of the substrate and consisting of an n-type InP crystal, (d) a graded layer 300 having stacked sublayers $310_1$ to $310_n$ ($310_1$ to $310_{n-1}$: thickness of about 1 $\mu$m, $310_n$: thickness of about 3 $\mu$m) sequentially epitaxially grown on the surface of the buffer layer 200 and consisting of two or more types of n-type InAsP mixed crystals having a different composition ratio, (e) a light-absorbing layer 400 (thickness of about 3 $\mu$m) epitaxially grown on the surface of the graded layer 300 and consisting of an n-type InGaAs mixed crystal having a lattice constant smaller than that of the uppermost mixed crystal sublayer $310_n$ of the graded layer, (f) a p-type doped zone 610 formed near the surface of the light-absorbing layer 400 and consisting of a Zn-doped InGaAs mixed crystal, (g) a p-type doped zone 620 (thickness of about 1 $\mu$m) formed on the surface of the p-type conductive layer 610, having almost the same lattice constant as that of the uppermost layer $310_n$ of the graded layer 300, and consisting of a Zn-doped InAsP mixed crystal, (h) a capping layer 500 (thickness of about 1 μm) formed on the surface of the light-absorbing layer 400 next to the p-type conductive layer 620, having almost the same lattice constant as that of the uppermost layer of the graded layer 300, and consisting of a compound semiconductor mixed crystal having a first conductivity type, (i) an insulating film 700 formed on the surfaces of the capping layer 500 and the p-type doped zone 620 and having an opening in the upper portion of the p-type doped zone 620, (j) an anti-reflection layer 710 formed on the surface of the p-type doped zone, and (k) a second electrode 920 connected to the p-type doped zone 620.

Light transmitted through the anti-reflection layer 710 reaches the light-absorbing layer 400 and is absorbed by the light-absorbing layer 400. This light absorption generates a signal charge in the light-absorbing layer 400, and a current is generated between the first and second electrodes. Hence, a function as a photodetector can be obtained. The light-absorbing layer 400 receives a tensile force from the uppermost layer $310_n$ of the graded layer 300, a capping layer 500, and a doped zone 620, which are formed on the upper or lower side of the light-absorbing layer 400 and have lattice constants larger than that of the light-absorbing layer 400. This tensile force serves to increase the lattice constant of the light-absorbing layer 400 and keep a dark current suppressed.

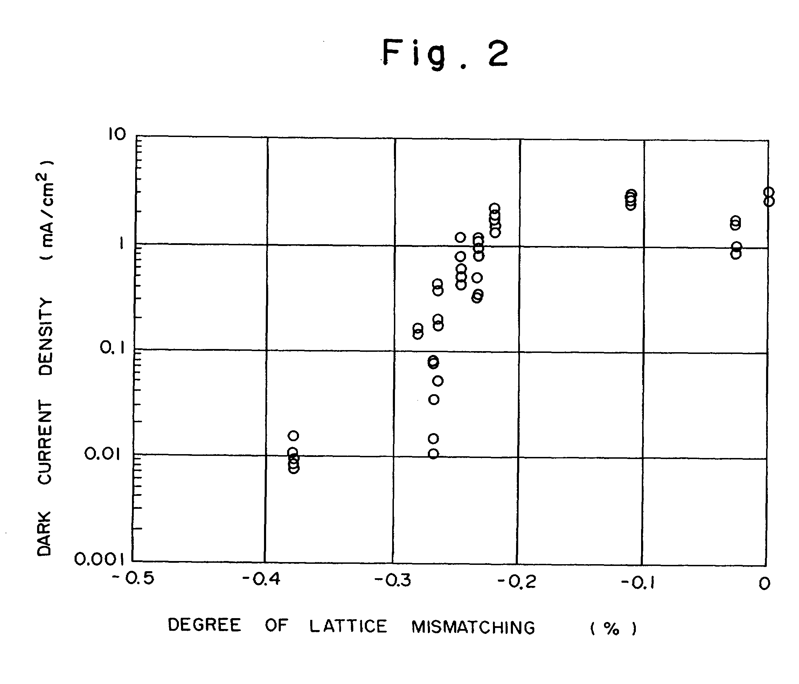

The present inventor manufactured semiconductor photodetector samples with the above structure having a light-absorbing layer consisting of $In_{0.65}Ga_{0.35}As$. These samples had various degrees of mismatching between the lattice constant of the light-absorbing layer and that of the uppermost layer of the graded layer or the capping layer. The relationship between the degree of lattice mismatching and a dark current density in the light-absorbing layer was obtained by experiments. Fig. 2 is a graph showing the experimental results and reduction of the dark current generated by mismatching between the lattice constant of the light-absorbing layer and that of the uppermost layer of the graded layer or the capping layer in the semiconductor photodetector with the above structure. The degree of mismatching between the lattice constants is plotted along the abscissa and represented by the following equation.

$$\Delta A/A = (\text{lattice constant of light absorption layer} - A)/A \qquad (1)$$

where A: lattice constant of the capping layer or the uppermost layer of the graded layer. The density of the dark current flowing in the light-absorbing layer is plotted along the ordinate. Referring to Fig. 2, as the degree of mismatching between the lattice constants increases, the dark current density exponentially decreases. When the degree of lattice mismatching falls within a range of $-0.5\% \leq \Delta A/A \leq -0.2\%$ rather than $-0.2\% < \Delta A/A \leq 0\%$, the dark current decreases by 10 to 100 times. When the degree of lattice mismatching satisfies $\Delta A/A < -0.5\%$, no satisfactory epitaxial layer can be obtained.

The present invention is not limited to the above embodiment, and modifications can be made. For example, the graded layer may be formed by epitaxially growing a $GaAs_{1-y}P_y$ mixed crystal on a GaAs bulk crystal while changing a value y. If the conditions of the lattice constant and the epitaxial growth are properly set, the semiconductor photodetector of the present invention can be constituted using other compound semiconductor materials.

As has been described above, according to the semiconductor photodetector of the present invention, the layers having lattice constants larger than that of the light-absorbing layer are formed on or under the light-absorbing layer. For this reason, when the light-absorbing layer is illuminated, a current is generated in accordance with the energy amount of the absorbed light to provide a function as a photodetector, as in the prior art. At the same time, the light-absorbing layer receives a tensile force from the upper and lower layers. This tensile force serves to increase the lattice constant of the light-absorbing layer, thereby realizing a semiconductor photodetector for effectively suppressing a dark current.

## Claims

1. A semiconductor photodetector comprising:

   a substrate (100) consisting of a compound semiconductor crystal having a first conductivity type;
   a first electrode (910) formed on a first surface of said substrate;
   a graded layer (300) having stacked mixed crystal sublayers ($310_1$, $310_2$, ... $310_n$) sequentially epitaxially grown on the second surface of said substrate (100) and consisting of at least two types of compound semiconductors having the first conductivity type and different composition ratios;
   a light-absorbing layer (400) epitaxially grown on the surface of said graded layer;
   a capping layer (500), formed on the surface of said light-absorbing layer (400), and consisting of a compound semiconductor mixed crystal having the first conductivity type;
   a first doped diffused zone (620) extending in said capping layer (500), and having a second conductivity type;

and
a second electrode formed on a surface of said first doped zone (620),

   characterised in that:

a second doped diffused zone (610) having a second conductivity type is formed adjacent said first doped zone (620) in the surface of said light-absorbing layer (400);
in that the capping layer (500) and the sublayer (310n) adjacent the light-absorbing layer (400) have almost the same lattice constants which are greater than that of the light-absorbing layer (400), the degree of mismatch between the lattice constant of the light-absorbing layer (400) and the lattice constants of each of the capping layer (500) and the said sublayer (310n) respectively being between -0.5% and -0.2%, whereby a dark current of the semiconductor photodetector is decreased by tensile forces acting in the direction of the respective interfaces between the light-absorbing layer and each of the capping layer (500) and the sublayer (310n), said forces tending to increase the lattice constant of the light-absorbing layer (400).

2. A device according to claim 1, wherein:

   said substrate (100) consists of an n-type InP crystal:
   said graded layer (300) consists of at least two n-type InAsP mixed crystal sublayers having different composition ratios of As and P to In;
   said light-absorbing layer (400) consists of an n-type InGaAs mixed crystal; and
   said capping layer (500) consists of an n-type InAsP mixed crystal.

3. A device according to claim 2, wherein said second doped zone (610) is a Zn diffused zone extending in said InGaAs mixed crystal forming said light-absorbing layer (400).

4. A device according to claim 2 or 3, wherein said first doped zone (620) is a Zn diffused zone extending in said InAsP mixed crystal forming said capping layer (500).

5. A device according to any of claims 1 to 4, further comprising between said substrate (100) and said graded layer (300) a buffer layer (200) consisting of said compound semiconductor crystal having the first conductivity type.

6. A device according to claim 5, wherein said buffer layer (200) consists of an n-type InP crystal.

**Patentansprüche**

1. Halbleiter-Photodetektor mit

   einem aus einem Verbindungshalbleiterkristall eines ersten Leitungstyps bestehenden Substrat (100),
   einer auf einer ersten Oberfläche des Substrats ausgebildeten ersten Elektrode (910),
   einer Gradientenschicht (300) mit gestapelten Mischkristallunterschichten ($310_1$, $310_2$, ... $310_n$), die aufeinanderfolgend auf eine zweite Oberfläche des Substrats (100) epitaktisch aufgewachsen sind und aus zumindest zwei Arten von Verbindungshalbleitern des ersten Leitungstyps mit verschiedenen Zusammensetzungsverhältnissen bestehen,
   einer auf einer Oberfläche der Gradientenschicht epitaktisch aufgewachsenen lichtabsorbierenden Schicht (400),
   einer Abdeckungsschicht (500), die auf einer Oberfläche der lichtabsorbierenden Schicht (400) ausgebildet ist und aus einem Verbindungshalbleitermischkristall des ersten Leitungstyps besteht,
   einem sich in die Abdeckungsschicht (500) erstreckenden ersten dotierten Diffusionsbereich (620) eines zweiten Leitungstyps und
   einer auf einer Oberfläche des ersten dotierten Bereichs (620) ausgebildeten zweiten Elektrode,

**dadurch gekennzeichnet, daß**

   ein zweiter dotierter Diffusionsbereich (610) eines zweiten Leitungstyps angrenzend zu dem ersten dotierten Bereich (620) in einer Oberfläche der lichtabsorbierenden Schicht (400) ausgebildet ist, und daß die Abdeckungsschicht (500) und die an die lichtabsorbierende Schicht (400) angrenzende Unterschicht (310n) nahezu die gleichen Gitterkonstanten aufweisen, die größer als die der lichtabsorbierenden Schicht (400) sind, wobei das Ausmaß der Gitterfehlanpassung zwischen der lichtabsorbierenden Schicht (400) einerseits und der Abdeckungsschicht (500) und der Unterschicht (310n) andererseits zwischen -0,5% und -0,2% liegt, wodurch ein Dunkelstrom des Halbleiter-Photodetektors durch Zugkräfte verringert wird, welche in Richtung der jeweiligen Grenzflächen zwischen der lichtabsorbierenden Schicht und der Abdeckungsschicht (500) sowie der Unterschicht (310n) wirken, wobei die Kräfte eine Erhöhung der Gitterkonstante der lichtabsorbierenden Schicht (400) begünstigen.

2. Vorrichtung nach Anspruch 1, wobei

das Substrat (100) aus einem n-dotierten InP-Kristall besteht,
die Gradientenschicht (300) aus zumindest zwei n-dotierten InAsP-Mischkristallunterschichten mit verschiedenen Zusammensetzungsverhältnissen von As und P zu In besteht,
die lichtabsorbierende Schicht (400) aus einem n-dotierten InGaAs-Mischkristall besteht, und
die Abdeckungsschicht (500) aus einem n-dotierten InAsP-Mischkristall besteht.

3. Vorrichtung nach Anspruch 2, wobei der zweite dotierte Bereich (610) ein Zn-Diffusionsbereich ist, der sich in den die lichtabsorbierende Schicht (400) ausbildenden InGaAs-Mischkristall erstreckt.

4. Vorrichtung nach Anspruch 2 oder 3, wobei der erste dotierte Bereich (620) ein Zn-Diffusionsbereich ist, der sich in den die Abdeckungsschicht (500) ausbildenden InAsP-Mischkristall erstreckt.

5. Vorrichtung nach einem der Ansprüche 1 bis 4, die zudem zwischen dem Substrat (100) und der Gradientenschicht (300) eine Pufferschicht (200) aus dem Verbindungshalbleiterkristall des ersten Leitungstyps aufweist.

6. Vorrichtung nach Anspruch 5, wobei die Pufferschicht (200) aus einem n-dotierten InP-Kristall besteht.

## Revendications

1. Photodétecteur à semi-conducteur, comprenant :

un substrat (100) constitué d'un cristal à semi-conducteur composite ayant un premier type de conductivité ;
une première électrode (910) formée sur une première surface du dit substrat ;
une couche calibrée (300) ayant des sous-couches de cristal mixte empilées ($310_1$, $310_2$, ... $310_n$) que l'on fait croître par épitaxie séquentielle sur une seconde surface du dit substrat (100) et constituée d'au moins deux types de semi-conducteurs composites ayant le premier type de conductivité et différents taux de composition ;
une couche absorbante de lumière (400) que l'on fait croître par épitaxie sur une surface de la dite couche calibrée ;
une couche de recouvrement (500) formée sur une surface de la dite couche absorbante de lumière (400) et constituée d'un cristal mixte semi-conducteur composite ayant le premier type de conductivité ;
une première zone dopée et diffusée (620) s'étendant dans la dite couche de recouvrement (500) et ayant un second type de conductivité ; et
une seconde électrode formée sur une surface de la dite première zone dopée (620),

caractérisé en ce que :

une seconde zone dopée et diffusée (610) ayant un second type de conductivité est formée en étant adjacente à la dite première zone dopée (620) dans une surface de la dite couche absorbante de lumière (400) ;
en ce que la couche de recouvrement (500) et la sous-couche ($310_n$) adjacente à la couche absorbante de lumière (400) ont presque les mêmes constantes de réseau qui sont supérieures à celles de la couche absorbante de lumière (400), le degré de non-correspondance entre la constante de réseau de la couche absorbante de lumière (400) et les constantes de réseau de chacune de la couche de recouvrement (500) et de la dite sous-couche ($310_n$) étant respectivement compris entre -0,5 % et -0,2 %, de sorte qu'un courant d'obscurité du photodétecteur à semi-conducteur est diminué sous l'effet des forces de traction agissant selon la direction des interfaces respectives entre la couche absorbante de lumière et chacune de la couche de recouvrement (500) et de la sous-couche ($310_n$), les dites forces tendant à accroître la constante de réseau de la couche absorbante de lumière (400).

2. Dispositif selon la revendication 1, dans lequel :

le dit substrat (100) est constitué d'un cristal InP du type n :
la dite couche calibrée (300) est constituée d'au moins deux sous-couches de cristal mixte InAsP du type n ayant différents taux de composition de As et de P à In ;
la dite couche absorbante de lumière (400) est constituée d'un cristal mixte InGaAs du type n ; et
la dite couche de recouvrement (500) est constituée d'un cristal mixte InAsP du type n.

3. Dispositif selon la revendication 2, dans lequel la dite seconde zone dopée (610) est une zone diffusée au Zn s'étendant dans le dit cristal mixte InGaAs formant la dite couche absorbante de lumière (400).

4. Dispositif selon la revendication 2 ou 3, dans lequel la dite première zone dopée (620) est une zone diffusée au Zn s'étendant dans le dit cristal mixte InAsP formant la dite couche de recouvrement (500).

5. Dispositif selon l'une quelconque des revendications 1 à 4, comprenant, en outre, entre le dit substrat (100) et la dite couche calibrée (300) une couche tampon (200) constituée du dit cristal à semi-conducteur composite ayant le premier type de conductivité.

6. Dispositif selon la revendication 5, dans lequel la dite couche tampon (200) est constituée d'un cristal InP du type n.

# Fig. 1

Fig. 2